# EUROPEAN PATENT SPECIFICATION

(11) **EP 0 749 108 B1**
(45) Date of publication and mention of the grant of the patent: **06.09.2000**
(21) Application number: 96108986.9
(22) Date of filing: 05.06.1996
(51) Int. Cl.: G10K 11/178, G10L 15/06, G01R 33/385

(54) **Anti-noise generating equipment for motor vehicles with alarm device**
Anti-Rauscherzeugungsgerät für Kraftfahrzeuge mit Alarmanlage
Dispositif générateur anti-bruit pour véhicules automobile ayant un dispositif d'alarme

(30) Priority: 15.06.1995 IT TO950499
(43) Date of publication of application: 18.12.1996
(73) Proprietor: MAGNETI MARELLI S.p.A., 20145 Milano (IT)
(72) Inventor: Corino, Silvio, 14010 Antignano D'Asti (AT) (IT); Cotignoli, Giuseppe, 10093 Collegno, Torino (IT); Mezzadri, Vittorio Antonio Domenico, 10036 Settimo Torinese, Torino (IT)
(74) Representative: Quinterno, Giuseppe

(56) References cited:
- EP-A- 0 622 640
- WO-A-91/15896
- DE-A- 4 106 405
- US-A- 4 856 072

## Description

The present invention relates in general to equipment for generating anti-noise for use in motor vehicles.

More specifically, this invention relates to equipment comprising
first acoustic-electric transducer means for providing electrical signals indicative of the noise generated in a space in the motor vehicle,
second electric-acoustic transducer means, and
an electronic processing and control unit which is connected to the first and second transducer means and, in one (first) operating mode, is adapted to pilot the second transducer means in dependence on the signals provided by the first so as to cause the generation, in said space, of pressure waves (anti-noise) which can at least partially cancel out the noise waves.

In known equipment of this type, microphones are typically used as acoustic-electric transducers and loud speakers as electric-acoustic transducers. In this equipment, the electronic processing and control unit is arranged to cause the generation, by means of the loud speakers, of pressure waves tending to be of same amplitude as the noise waves but in phase opposition thereto, in order to generate a cancelling effect with a consequent considerable reduction in the level of noise noticeable in the space controlled which, typically, is the passenger compartment of the motor vehicle.

In the prior art, WO-A-9115896 discloses a noise cancellation system for use in an automobile to reduce the noise level within a passenger compartment whereby an arrangement of loudspeakers generates an acoustic wave field of opposite polarity. The output signal of an assembly of microphones is processed by an electronic processing unit for driving the arrangement of loudspeakers. In EP-A-0622640 an ultrasonic anti-theft device is disclosed with a transmitter/receiver system which monitors the interior of an automobile to detect unauthorized intrusion. A voice actuated vehicle security system is disclosed in US-A-4856072 whereby a voice recognition system enables an authorized person to operate the vehicle security system.

The present invention proposes equipment for generating anti-noise of the type specified, characterized in that
it further comprises selector means capable of supplying to the processing and control unit signals for prearranging it selectively to implement a first operating mode or a second operating mode, alternative to the first, and in that
in the second operating mode, the unit is arranged to carry out the following steps:
   - to control the second transducer means so as to cause the generation, in said space, of pressure waves with predetermined characteristics,
   - to detect signals correspondingly provided by the first transducer means,
   - to compare predetermined characteristics of these signals with those of reference signals or data previously stored, and
   - to generate alarm and/or locking signals when the characteristics of the signals provided by the first transducer means differ significantly from those of the reference signals or data,
so that, in the second operating mode, the equipment operates as an alarm system against intrusions into said space.

According to a further characteristic, the equipment according to the invention is also characterized in that the processing and control unit is arranged
to acquire voice signals by means of the first transducer means,
to analyze and compare predetermined characteristics of the voice signals acquired with those of reference voice signals previously stored, and
to generate alarm and/or locking signals usable to prevent the operation of equipment or a device of the motor vehicle when the voice signals acquired differ significantly from the reference voice signals stored.

Further characteristics and advantages of the invention will become clear from the following detailed description given purely by way of non-limiting example with reference to the appended drawings, in which:
Figure 1 is a block diagram of equipment according to the invention, and
Figure 2 is a block diagram of a processing and control unit included in equipment according to the invention.

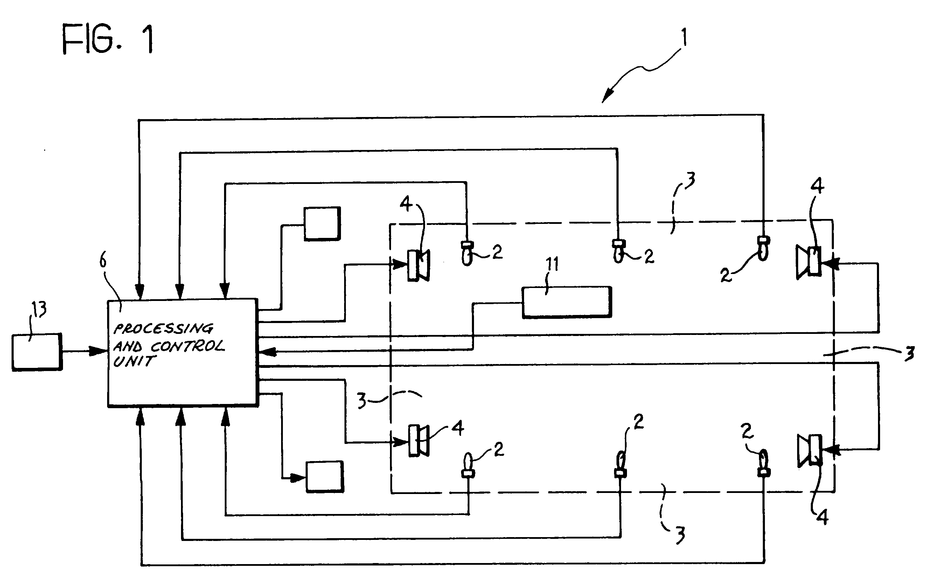

In Figure 1, equipment for generating anti-noise according to the invention is generally indicated 1.

In the embodiment shown by way of example, this equipment comprises six acoustic-electric transducers, particularly microphones, indicated 2, arranged in a space in the motor vehicle, particularly in the passenger compartment which is shown schematically in broken outline and indicated 3 in Figure 1.

The equipment also comprises, for example, four electric-acoustic transducers, particularly loud speakers or sets of loud speakers, indicated 4.

The microphones 2 and the loud speakers 4 are connected to corresponding inputs and to corresponding outputs, respectively, of an electronic processing and control unit, generally indicated 6.

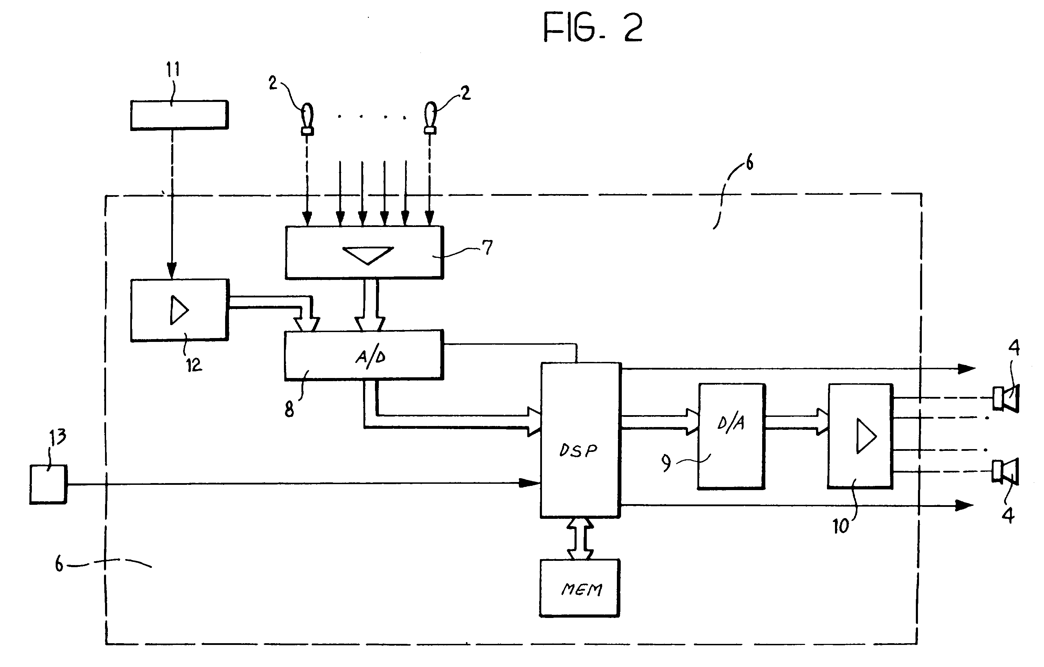

The processing and control unit 6 may be formed, for example, in the manner which will now be described with reference to Figure 2.

In this embodiment described by way of example, the unit 6 comprises signal-amplifying and -conditioning circuits, generally indicated 7, the inputs of which are connected to the microphones 2. The outputs of these circuits are connected to analog/digital conversion devices 8, the outputs of which are connected to a digital signal processor DSP with which memory devices MEM are associated.

The digital signal processor DSP is arranged, for example, by means of suitable programmes based, for example on "fuzzy logic" techniques, in a first operating mode, to acquire electrical signals or data generated by means of the microphones 2 and indicative of the noise generated in the region 3 of the motor vehicle. In dependence on the noise signals thus acquired, the digital signal processor pilots the loud speakers 4 by means of digital/analog conversion devices 9 and output amplifier stages 10 so as to cause the generation, in said space 3, of pressure waves (anti-noise) which can cancel out at least some of the noise waves.

"Car stereo" equipment, such as radio receivers, compact-disc readers, tape readers, etc. may also advantageously, but not necessarily, be connected to the processing and control unit 6, according to a known technique. The block indicated 11 in Figure 1 represents one or more of these devices.

The processing and control unit 6 may have suitable signal-amplifying and -conditioning circuits 12 the outputs of which are connected to the A/D conversion devices 8, as shown in Figure 2, in order to control the signals coming from the "car stereo" devices 11. The digital signal processor DSP is then correspondingly arranged to pilot the loud speakers 4 by means of the D/A convertors and the output amplifiers 10 so as to cause anti-noise pressure waves and vocal/musical sound signals to be generated simultaneously in said space 3.

The equipment described above, according to the invention, can operate as an alarm system against intrusions into the passenger compartment 3 as well as an anti-noise generation system.

For this purpose, the equipment also comprises a selector device, indicated 13 in Figure 1, which is connected to the processing and control unit 6 in order to provide this unit with signals for prearranging it selectively to implement the (first) operating mode described above or a second operating mode, alternative to the first, which will now be described.

The digital signal processor DSP is arranged to pilot the loud speakers 4 (by means of the D/A converter 9 and the amplifiers 10) so as to cause pressure waves of predetermined characteristics having, for example, frequencies within the ultrasound range, to be generated in the passenger compartment 3. The processor DSP is also arranged to acquire the signals correspondingly provided by the microphones 2, which constitute a representation of the "acoustic response" of the passenger compartment 3.

Data corresponding to the acoustic response of the passenger compartment 3 under predetermined conditions (passenger compartment closed and empty, etc.) are advantageously stored in the memories associated with the processor DSP and the acoustic response obtained by the activation of the loud speakers and the acquisition of the signals correspondingly supplied by the microphones 2 is periodically compared with these reference data. If the acoustic response detected differs significantly from that stored, the processor DSP generates an alarm and/or blocking signal.

In the second operating mode just described, the equipment thus advantageously achieves an effective and reliable volumetric protection of the space in the passenger compartment against intrusions.

The reference acoustic response of the passenger compartment can be stored in the memory devices associated with the processor DSP from the start or may be acquired by the processor, by means of a first activation of the loud speakers 4 and the corresponding acquisition of the signals supplied by the microphones 2, each time the motor vehicle is left.

Any alarm signals generated by the processor DSP in the second operating mode can be used to activate acoustic and/or optical alarm devices or to disable the operation of devices or units essential for the use of the motor vehicle. These signals can be used, for example, to prevent the engine of the motor vehicle from being started, etc..

The selector device 13 which prearranges the processing and control unit 6 to operate so as to generate anti-noise or as an anti-intrusion system may be constituted, for example, by a device which can receive a signal from a remote-control device such as those currently used for the remote control of the closing/opening of the motor-vehicle doors.

Alternatively, the selector device 13 may be constituted by a sensor which can detect the inserted/non-inserted condition of the ignition and starter switch key of the motor vehicle in order to enable the processing and control unit 6 to generate anti-noise waves when the key is inserted in the ignition and starter switch and is disposed in the "running" position. The enabling of the anti-noise wave generation may also possibly be conditional upon the detection of the running condition of the engine by means of sensor devices of known type, not shown.

The selector device 13 may be formed in various other ways which are clear to experts in the art. It may, for example, be constituted by a simple switch operable manually by the user.

The equipment according to the invention described above achieves an advantageous functional synergy.

A further advantageous functional synergy may be achieved by the arrangement of the processor DSP, in the second operating mode described above, to acquire voice signals by means of the associated microphones 2 and to analyze and compare predetermined characteristics of the voice signals thus acquired with those of reference voice signals previously stored and to generate alarm or locking signals when the signals acquired differ significantly from those stored. This additional function enables the equipment according to the invention to operate as a voice-identification and -recognition system. One or more passwords can thus be stored in the memories associated with the processor DSP for each authorized user of the motor vehicle, the processor DSP being arranged to compare the password spoken by a user entering the passenger compartment with that stored in order to generate a signal to enable/disable devices or equipment essential for the use of the motor vehicle.

The recognition, at voice level, of a password spoken by the user of the motor vehicle may also be used for prearranging the processing and control unit 6 to operate in the second operating mode (anti-intrusion system) and for arranging the unit to operate so as to generate anti-noise waves again.

In the case of motor vehicles having devices which are adjustable electrically in a programmable manner, such as electrically adjustable seats and rear-view mirrors, etc., the vocal password-recognition capability enables corresponding personalized arrangements of these devices to be associated with certain passwords.

Naturally, the principle of the invention remaining the same, the forms of embodiment and details of construction may be varied widely with respect to those described and illustrated purely by way of non-limiting example, without thereby departing from the scope of the present invention as defined in the appended Claims.

## Claims

1. Equipment (1) for generating anti-noise for motor vehicles, comprising
first acoustic-electric transducer means (2) for providing electrical signals indicative of the noise in a space (3) in the motor vehicle,
second electric-acoustic transducer means (4), and
an electronic processing and control unit (6) which is connected to the first and second transducer means (2, 4) and, in a first operating mode, is adapted to control the second transducer means (4) in dependence on the signal provided by the first (2) so as to cause the generation, in said space (3), of anti-noise pressure waves which can cancel out at least some of the noise waves,
characterized in that
the equipment (1) also comprises selector means (13) capable of supplying to the control unit (6) signals for selectively prearranging it to implement the first operating mode or a second operating mode, alternative to the first, and in that
in the second operating mode, the unit (6) is arranged to carry out the following operations:
- to control the second transducer means (4) so as to cause the generation of pressure waves of predetermined characteristics in said space (3),
- to detect the signals correspondingly provided by the first transducer means (2),
- to compare predetermined characteristics of these signals with those of reference signals or data previously stored, and
- to generate alarm and/or locking signals when the characteristics of the signals provided by the first transducer means (2) differ significantly from those of the reference signals or data, so that, in the second operating mode, the equipment (1) operates as an alarm system against intrusions into said space (3).

2. Equipment according to Claim 1, characterized in that the first and second transducer means (2, 4) are arranged to operate in the audible sound-frequency range in the first operating mode, and the first and second transducer means (2, 4) are also arranged to operate in the ultrasonic sound-frequency range in the second operating mode.

3. Equipment according to Claim 1 or Claim 2, characterized in that the processing and control unit (6) is also arranged:
to acquire voice signals by means of the first transducer means (2),
to analyze and compare predetermined characteristics of the voice signals acquired with those of reference voice signals previously stored, and
to generate alarm and/or locking signals usable to prevent the operation of equipment or a device of the motor vehicle when, upon the basis of a predetermined criterion, the voice signals acquired differ significantly from the reference voice signals stored.

## Patentansprüche

1. Vorrichtung (1) zur Raumgeräuschunterdrückung für Kraftfahrzeuge, umfassend
erste, akustoelektrische Wandlereinrichtungen (2) zur Lieferung elektrischer Signale, die das Geräusch in einem Raum (3) im Kraftfahrzeug anzeigen,
zweite, elektroakustische Wandlereinrichtungen (4) und
eine elektronische Verarbeitungs- und Steuereinheit (6), die an die ersten und zweiten Wandlereinrichtungen (2, 4) angeschlossen ist und in einem ersten Arbeitsmodus die zweiten Wandlereinrichtungen (4) in Abhängigkeit von dem durch die ersten Wandlereinrichtungen (2) gelieferten Signal steuern kann, sodass die Erzeugung von geräuschunterdrückenden Druckwellen in besagtem Raum (3) bewirkt wird, die zumindest einen Teil der Geräuschwellen ausschalten können,
dadurch gekennzeichnet, dass
die Vorrichtung (1) auch eine Auswahleinrichtung (13) aufweist, die Signale an die Steuereinheit (6) zur selektiven Voreinstellung derselben zwecks Implementierung des ersten Arbeitsmodus oder eines zweiten Arbeitsmodus alternativ zum ersten liefern kann, und dass
im zweiten Arbeitsmodus die Einheit (6) so eingestellt ist, dass sie die folgenden Operationen ausführt:
- Steuerung der zweiten Wandlereinrichtungen (4) zwecks Bewirkens der Erzeugung von Druckwellen vorbestimmter Kenndaten in dem Raum (3),
- Detektion der von den ersten Wandlereinrichtungen (2) entsprechend gelieferten Signale,
- Vergleich der vorbestimmten Kenndaten dieser Signale mit jenen von zuvor gespeicherten Referenzsignalen oder -daten, und
- Erzeugung von Alarm- und/oder Verriegelungssignalen bei einer signifikanten Abweichung der Kenndaten der von den ersten Wandlereinrichtungen (2) gelieferten Signale von jenen der Referenzsignale oder -daten derart, dass die Vorrichtung (1) im zweiten Arbeitsmodus als Alarmsystem gegen Intrusionen in den Raum (3) fungiert.

2. Vorrichtung nach Anspruch 1, dadurch gekennzeichnet, dass die ersten und zweiten Wandlereinrichtungen (2, 4) derart eingestellt sind, dass sie im ersten Arbeitsmodus im hörbaren Schallfrequenzbereich arbeiten, und dass die ersten und zweiten Wandlereinrichtungen (2, 4) auch derart eingestellt sind, dass sie im zweiten Arbeitsmodus im Ultraschallfrequenzbereich arbeiten.

3. Vorrichtung nach Anspruch 1 oder 2, dadurch gekennzeichnet, dass die Verarbeitungs- und Steuereinheit (6) auch eingestellt ist
zur Erfassung von Sprachsignalen mittels der ersten Wandlereinrichtungen (2),
zur Analyse und zum Vergleich vorbestimmter Kenndaten der erfassten Sprachsignale mit jenen von zuvor gespeicherten Referenz-Sprachsignalen, und
zur Erzeugung von Alarm- und/oder Verriegelungssignalen, die zur Verhinderung der Funktion der Vorrichtung oder einer Einrichtung des Kraftfahrzeugs bei einer signifikanten Abweichung der erfassten Sprachsignale von den gespeicherten Referenz-Sprachsignalen auf Basis eines vorbestimmten Kriteriums verwendbar sind.

## Revendications

1. Equipement (1) destiné à générer de l'anti-bruit pour des véhicules à moteur, comportant
des premiers moyens de transducteur acousto-électrique (2) destinés à délivrer des signaux électriques indicatifs du bruit existant dans un espace (3) du véhicule à moteur,
des seconds moyens de transducteur électro-acoustique (4), et
une unité de traitement et de commande électronique (6) qui est reliée aux premiers et seconds moyens de transducteur (2, 4) et qui, dans un premier mode de fonctionnement, est adaptée pour commander les seconds moyens de transducteur (4) en fonction du signal délivré par les premiers moyens de transducteur (2) de manière à amener à ce que soient générées, dans ledit espace (3), des ondes de pression anti-bruit capables de faire disparaître au moins certaines des ondes de bruit,
caractérisé en ce que
l'équipement (1) comporte aussi des moyens de sélection (13) qui sont capables de délivrer à l'unité de commande (6) des signaux la préparant d'une manière sélective à implémenter le premier mode de fonctionnement ou un second mode de fonctionnement, différent du premier, et en ce que
dans le second mode de fonctionnement, l'unité (6) est disposée à implémenter les opérations suivantes:
- commander les seconds moyens de transducteur (6) de manière à amener à ce que soient générées des ondes de pression de caractéristiques prédéterminées dans ledit espace (3),
- détecter les signaux délivrés d'une manière correspondante par les premiers moyens de transducteur (2),
- comparer les caractéristiques prédéterminées de ces signaux à celles de signaux ou données de référence mémorisés auparavant, et
- générer des signaux d'alarme et/ou de verrouillage lorsque les caractéristiques des signaux délivrés par les premiers moyens de transducteur (2) diffèrent fortement de celles des signaux ou données de référence, de sorte que, dans le second mode de fonctionnement, l'équipement (1) se comporte comme un système d'alarme contre les intrusions dans ledit espace (3).

2. Equipement selon la revendication 1, caractérisé en ce que les premiers et seconds moyens de transducteur (2, 4) sont conçus de manière à fonctionner dans la plage de fréquences des sons audibles dans le premier mode de fonctionnement, et les premiers et seconds moyens de transducteur (2, 4) sont aussi conçus de manière à fonctionner dans la plage de fréquences des ultrasons dans le second mode de fonctionnement.

3. Equipement selon la revendication 1 ou 2, caractérisé en ce que l'unité de traitement et de commande (6) est aussi conçue de manière à:
faire l'acquisition de signaux vocaux par l'intermédiaire des premiers moyens de transducteur (2),
analyser et comparer des caractéristiques prédéterminées des signaux vocaux acquis à celles de signaux vocaux de référence mémorisés auparavant, et
générer des signaux d'alarme et/ou de verrouillage utilisables pour empêcher le fonctionnement de l'équipement ou d'un dispositif du véhicule à moteur lorsque, sur la base d'un critère prédéterminé, les signaux vocaux acquis diffèrent fortement des signaux vocaux de référence mémorisés.
